# EUROPÄISCHE PATENTSCHRIFT

(11) **EP 0 338 102 B1**
(45) Veröffentlichungstag und Bekanntmachung des Hinweises auf die Patenterteilung: **10.03.1993**
(21) Anmeldenummer: 88106205.3
(22) Anmeldetag: 19.04.1988
(51) Int. Cl.: H01L 21/28, H01L 21/00

(54) **Verfahren zur Herstellung von integrierten Halbleiterstrukturen welche Feldeffekttransistoren mit Kanallängen im Submikrometerbereich enthalten**
Process for manufacturing semiconductor integrated circuits comprising field effect transistors having submicron channels
Procédé de fabrication de circuits intégrés à semi-conducteurs comportant des transistors à effet de champ ayant des canaux submicroniques

(43) Veröffentlichungstag der Anmeldung: 25.10.1989
(73) Patentinhaber: International Business Machines Corporation, Armonk, N.Y. 10504 (US)
(72) Erfinder: Koblinger, Otto, Dr., D-7015 Korntal-Münchingen 2 (DE); Mühl, Reinhold, D-7031 Altdorf (DE); Trumpp, Hans-Joachim, Dr., D-7024 Filderstadt (DE)
(74) Vertreter: Mönig, Anton, Dipl.-Ing.

(56) Entgegenhaltungen:
- EP-A- 0 098 318
- EP-A- 0 146 789
- MICROELECTRONIC ENGINEERING, Band 3, Nr. 1/4, Dezember 1985, Seiten 519-524, Elsevier Science Publishers B.V., Amsterdam, NL; J. CARO et al.: "Submicron gate level process step using E-beam lithography"
- IBM TECHNICAL DISCLOSURE BULLETIN, Band 25, Nr. 11B, April 1983, Seiten 6185-6186, New York, US; J. GRESCHNER et al.: "Lithographic method for defining edge angles"
- OPTICAL ENGINEERING, Band 22, Nr. 2, März/April 1983, Seiten 185-189, Bellingham, Washington, US; J.N. HELBERT et al.: "Intralevel hybrid resist process for the fabrication of metal oxide semiconductor devices with submicron gate lengths"

## Beschreibung

Die Erfindung betrifft ein Verfahren zur Herstellung von integrierten Halbleiterstrukturen, welche Feldeffekt- transistoren mit Kanallängen im Submikrometerbereich enthalten.

In der heutigen Halbleitertechnologie ist es wünschenswert, Linienbreiten im Bereich von etwa 0.5 µm unter Anwendung von Standardphotolithographieverfahren zu erhalten und die Anwendung komplexerer Technologien wie Elektronen- oder Röntgenstrahllithographie zu vermeiden. Es wurden in den letzten Jahren beträchtliche Anstrengungen unternommen, um Prozesse für die Herstellung von Feldeffekttransistoren mit Kanallängen im Submikrometerbereich zu entwickeln, bei gleichzeitiger Einhaltung sehr enger Kanallängentoleranzen. Beispiele dieser Arbeiten sind beschrieben in den U.S. Patentschriften 4,209,349; 4,209,350; 4,234,362; 4,256,514, and 4,502,914. In allen diesen Patentschriften werden Verfahren zur Herstellung eines Siliciumkörpers mit im wesentlichen horizontalen und im wesentlichen vertikalen Oberflächen beschrieben, auf denen dann eine sehr dünne Schicht abgeschieden wird. In einem anisotropen Ätzverfahren, beispielsweise durch reaktives Ionenätzen, wird die Schicht auf der im wesentlichen horizontalen Oberfläche entfernt, während die Schicht auf der im wesentlichen vertikalen Oberfläche erhalten bleibt. Die Dimension der vertikalen Schicht hängt im wesentlichen von der Schichtdicke der ursprünglich aufgetragenen Schicht ab.

Auf diese Weise kann ein Bereich mit sehr kleinen Dimensionen hergestellt werden, beispielsweise ein Kanal eines Feldeffekttransistors mit einer Länge im Submikrometerbereich.

Ein anderes Verfahren verwendet ein Dreilagenresistsystem, um die Gateelektrode eines Feldeffekttransistors durch Photo- oder Elektronenstrahllithographie zu definieren. Bei diesem Verfahren (siehe beispielsweise PCT-Anm. WO-80/00639) wird als Basis eine verhältnismäßig dicke Polymer- oder Resistschicht auf die Oberfläche einer polykristallinen Siliciumschicht, die zum Teil als Gateelektrode vorgesehen ist, aufgetragen. Nach einem Aushärtschritt wird eine Zwischenschicht aus Siliciumdioxid oder Nitrid durch chemische Abscheidung aus der Dampfphase aufgetragen. In der obersten Schicht, welche aus einem hochempfindlichen positiven oder negativen Photoresist besteht, wird das gewünschte Muster der Gateelektrode durch optische oder Elektronenstrahlbelichtung und Entwicklung erzeugt. Die Übertragung des Musters von der oberen Resistschicht in die Siliciumdioxid- oder Nitridsperrschicht erfolgt durch reaktives Ionenätzen oder Plasmaätzen mit CF₄, CHF₃, ggf. im Gemisch mit O₂ und dergl., und durch reaktives Ionenätzen mit O₂ wird das Muster in die untere Polymer- oder Resistschicht übertragen. Bei diesem Ätzschritt wird ein relativ hoher Sauerstoffdruck von etwa 50 bis 70 µbar angewendet, um eine laterale Unterätzung der Siliciumdioxid/nitrid-Sperrschicht um einen gewünschten Betrag, beispielsweise um etwa 0.2 µm je Seite zu erreichen. Die gegenüber der Ausgangslinienbreite in der oberen Resistschicht um die laterale Unterätzung verschmälerten Photoresiststege der unteren Schicht dienen beim anschließenden reaktiven Ionenätzen des Polysiliciums als Maske.

Nachteilig an diesem Verfahren ist seine schlechte Uniformität. So hat es sich beispielsweise gezeigt, daß der Fuß der Photoresiststege nicht sehr genau definiert ist und dass deren Breite auf Chips von Wafermitte zu Waferrand stark differiert. Hinzu kommt, daß die mittlere, laterale Unterätzung durch die Geometrie der gewünschten Strukturen auf einen bestimmten Wert begrenzt ist und die Ätzrate für die laterale Unterätzung zeitlich nicht konstant ist. Ausserdem wird der Einfluß von benachbarten Strukturen während des Ätzens durch den Überhang der Siliciumdioxid/nitrid-Sperrschicht verstärkt. Ein weiterer Nachteil dieses Verfahrens ist, dass, bedingt durch die fassartige Form der Photoresiststege, beim reaktiven Ionenätzen in das Polysilicium ein negativer Winkel gebildet wird, der während der nachfolgenden Herstellung der Abstandshalter durch Abscheidung und reaktives Ionenätzen und der Ionenimplantation der Source- und Draingebiete zu starken Schwankungen der effektiven Kanallängen von FET's führt.

Aufgabe der Erfindung ist, ein verbessertes Verfahren anzugeben, das zur Herstellung einer Resist- oder Polymermaske einen Dreilagenresist verwendet und bei dem durch reaktives Ionenätzen die Dimensionen der Photoresistmaske der oberen Schicht mit grosser Präzision in die untere Resist- oder Polymerschicht übertragen und die Linienbreiten der so hergestellten Resist- oder Polymermaske durch laterales Ätzen in definierter Weise verschmälert werden können. Die Resist- oder Polymermaske dient beim anschließenden reaktiven Ionenätzen des Polysiliciums als Maske und gestattet die Herstellung eines positiven Winkels im Polysilicium, der sowohl für eine gute Definition der Abstandshalter auf den Polysiliciumkanten und der Ionenimplantation sehr erwünscht ist.

Die Aufgabe der Erfindung wird gelöst durch ein Verfahren gemäß Patentanspruch 1.

Die Erfindung wird nachfolgend anhand der speziellen Beschreibung und der Fign. 1 bis 4 näher erläutert.

Es zeigen:
- Fig. 1: eine Dreilagenstruktur zur Herstellung einer Resist- oder Polymermaske;
- Fign. 2A - 2B: ein Verfahren nach dem Stand der Technik;
- Fign. 3A - 3F: das Verfahren gemäß der Erfindung:
- Fign. 4A - 4F: eine Variante des Verfahrens gemäß der Erfindung.

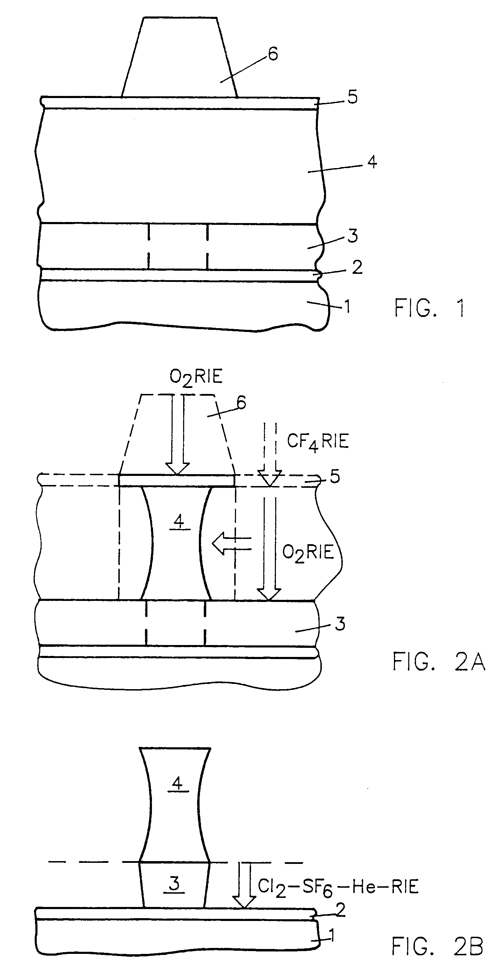

Die Schichtstruktur, welche in Fig. 1 dargestellt ist, ist Ausgangspunkt für das Verfahren nach dem Stand der Technik und für das Verfahren gemäß der Erfindung.

Zur Herstellung der Schichtstruktur wird auf ein VLSI-Substrat (1) aus Silicium eine isolierende Schicht (2) aufgetragen. Diese Schicht kann aus thermisch aufgewachsenem Siliciumdioxid bestehen, wobei ein Teil der Schicht auf dem Substrat als Gate-Dielektrikum vorgesehen ist. Die Schicht kann auch aus Siliciumdioxid, Siliciumnitrid und dergl. aufgebaut sein, beispielsweise aus einer Kombination von Siliciumdioxid, Siliciumnitrid und Siliciumdioxid. Die Siliciumdioxidschicht wird vorzugsweise thermisch aufgewachsen in einer Sauerstoff- oder Sauerstoff-Wasser-Umgebung bei einer Temperatur von etwa 800°C.

Eine Siliciumnitridschicht wird üblicherweise durch chemische Abscheidung aus der Dampfphase unter Verwendung eines SiH₄/NH₃ Gasgemisches und N₂ als Trägergas bei einer Temperatur von etwa 800°C unter atmosphärischem Druck oder unter Vakuumbedingungen hergestellt.

In der Schichtstruktur, die in Fig. 1 dargestellt ist, besteht die isolierende Schicht (2) beispielsweise aus Siliciumdioxid in einer Schichtdicke von etwa 13 nm. Die Oberflächenleitfähigkeit des P- Substrats (1) wird in den Bereichen, in denen Feldeffekttransistoren gebildet werden, durch Ionenimplantation auf einen bestimmten Schwellwert Vt eingestellt.

Anschließend wird eine polykristalline Siliciumschicht (3) auf der gesamten Oberfläche der Siliciumdioxidschicht (2) abgeschieden unter Verwendung von Silan in einer Wasserstoffumgebung, in einem Temperaturbereich von etwa 600°C bis etwa 650°C, vorzugsweise bei einer Temperatur von etwa 625°C. Die Dicke der abgeschiedenen Polysiliciumschicht (3) beträgt etwa 400 bis 500 nm, vorzugsweise 430 nm. Die ganze Oberfläche der Schicht (3) wird durch Implantation von Phosphor oder Arsen dotiert, und anschließend werden die Substrate auf etwa 900°C erhitzt.

Zur Herstellung der Photoresist- oder Polymermaske wird auf die Oberfläche der Polysiliciumschicht (3) eine etwa 1 bis etwa 2 µm dicke Polymer- oder Resistschicht (4) durch Aufschleudern oder Aufsprühen aufgetragen, gefolgt von einem Aushärteschritt bei etwa 200°C für etwa 30 Min. Es gibt zahlreiche Materialien, aus denen die Schicht (4) hergestellt werden kann. Es können bekannte positive und negative Photoresistmaterialien, beispielsweise die üblichen Phenol-Formaldehyd-Novolakharze, Polymethylmethacrylate, Polyisoprene oder Materialien, die in den U.S. Patent- schriften 3,201,239 und 3,770,433 beschrieben sind, verwendet werden. Es können aber auch Polymermaterialien, die keine Photoleiter sind, z. B. Polyimide, zur Ausbildung der Schicht (4) verwendet werden.

In dem Verfahren gemäß der Erfindung wird als Schicht (4) der TNS-Photoresist aufgetragen, der in der U.S. Patentschrift 4,397,937 beschrieben ist und auf einem Phenolharz und einem Bisester einer 1-Oxo-2-naphthalinsulfonsäure mit einem asymmetrischen pri- mären oder sekundären aliphatischen Diol als Sensibilisator basiert. Die Schichtdicke beträgt etwa 1.1 µm. Die Schicht (4) wird unter den oben angegebenen Bedingungen ausgehärtet.

Im Anschluß daran wird auf die Schicht (4) als Ätzbarriere für das reaktive Ionenätzen mit Sauerstoff eine Siliciumnitridschicht (5) in einer Schichtdicke von etwa 0.1 µm aufgetragen. Das Siliciumnitrid wird durch Plasmaabscheidung aus einer Silan, Ammoniak und Argon haltigen Atmosphäre bei einem Druck von etwa 1 mbar, einer Abscheidungstemperatur von etwa 200°C und einer Energiedichte von etwa 0.05 Watt/cm² niedergeschlagen.

Auf die Plasma-Siliciumnitridschicht (5) wird als oberste Schicht eine Photoresistschicht (6) in einer Dicke von etwa 0.5 µm bis 1.0 µm aufgetragen. Die Schicht besteht in dem Verfahren gemäß der Erfindung aus dem gleichen Photoresist wie die Resistschicht (4). Sie kann aber auch aus einem anderen, gegen Strahlung hochempfindlichen Photoresist bestehen.

In der Schicht (6) wird in einem Verfahren nach dem Stand der Technik durch Belichten mit einer Wellenlänge von 436 nm, gefolgt von einem Aushärtschritt in Stickstoff bei einer Temperatur im Bereich von etwa 95 bis etwa 105°C für etwa 30 Min. und Entwickeln in wäßrigem AZ-Entwickler auf der Basis von Tetramethylammoniumhydroxid das gewünschte Maskenmuster erzeugt.

Das Muster der Photoresistmaske (6) wird dann mittels Trockenätzverfahren in die Nitridschicht (5) und in die Resistschicht (4) übertragen, wobei das Ätzen von Öffnungen in die Siliciumnitridschicht (5) (Fig. 2A) durch Plasmaätzen mit CF₄, bei einem Fluß von etwa 20 bis 50 sccm, einem Druck von etwa 30 bis 60 µbar und einer Energiedichte von etwa 0.3 bis 0.5 Watt/cm², mit etwa 30 %iger Überätzung erfolgt. Der Endpunkt der Ätzung wird jeweils mittels Laserinterferenz bestimmt. Die Schicht (5) mit den geätzten Öffnungen dient als Maske zum Ätzen der Resist- bzw. Polymerschicht (4). Bisher wurde zum reaktiven Ionenätzen dieser Schicht Sauerstoff mit einem relativ hohen Druck von etwa 50 bis 70 µbar verwendet, um eine laterale Unterätzung der Siliciumnitridschicht (5) um einen gewünschten Betrag zu erreichen. Bei diesem Ätzschritt wird die Resistschicht (4) anisotrop, d. h. senkrecht geätzt, und gleichzeitig findet, bedingt durch die isotropen Anteile des Ätzmediums, eine laterale Unterätzung der Nitridmaske (5) statt, wodurch gegenüber der Ausgangslinienbreite in der oberen Schicht (6) in der unteren Schicht (4) verschmälerte Photoresiststrukturen erhalten werden. Während der Ätzung der Schicht (4) wird auch die Resistmaske (6) auf der Nitridmaske (5) vollständig entfernt.

Wie bereits eingangs geschildert, weist dieses Verfahren beträchtliche Nachteile hinsichtlich der Uniformität der Ätzung auf, so dass die gewünschten Toleranzen für die Breite der Photoresiststrukturen nicht überall eingehalten werden können. Ein weiterer, gravierender Nachteil ist, dass die fassartige Form der Photoresiststege, die bei der lateralen Unterätzung der Nitridmaske (5) erhalten wird, für die nachfolgende Ätzung der Polysiliciumschicht (3) ungünstig ist. Beim reaktiven Ionenätzen der Polysiliciumschicht (3) (Fig. 2B), beispielsweise mit Cl₂/SF₆/He, wird bei Verwendung einer derartigen Photoresistmaske ein negativer Winkel im Polysilicium erhalten, der im Hinblick auf die Eigenschaften der FET's unerwünscht ist.

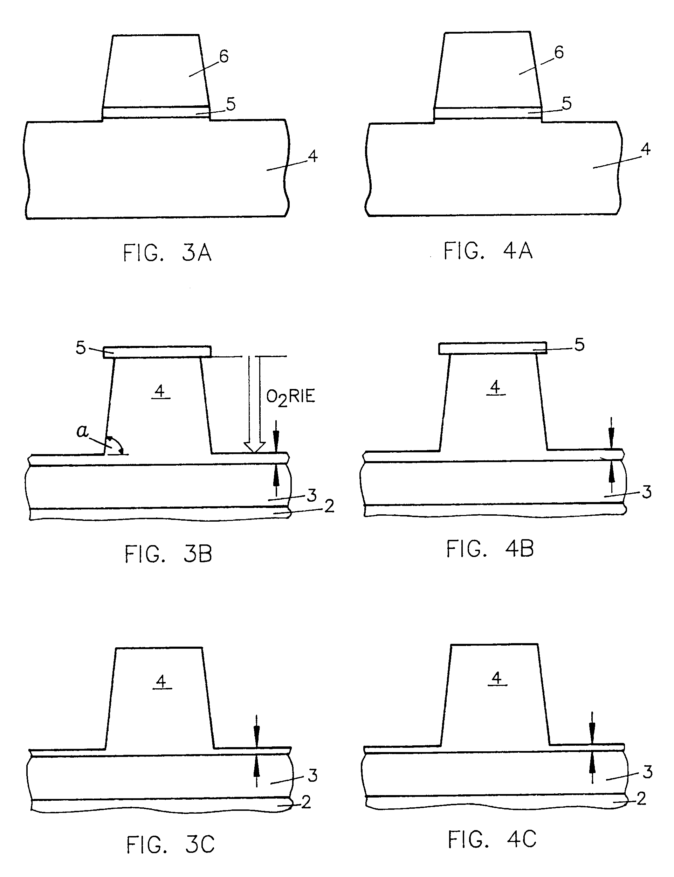

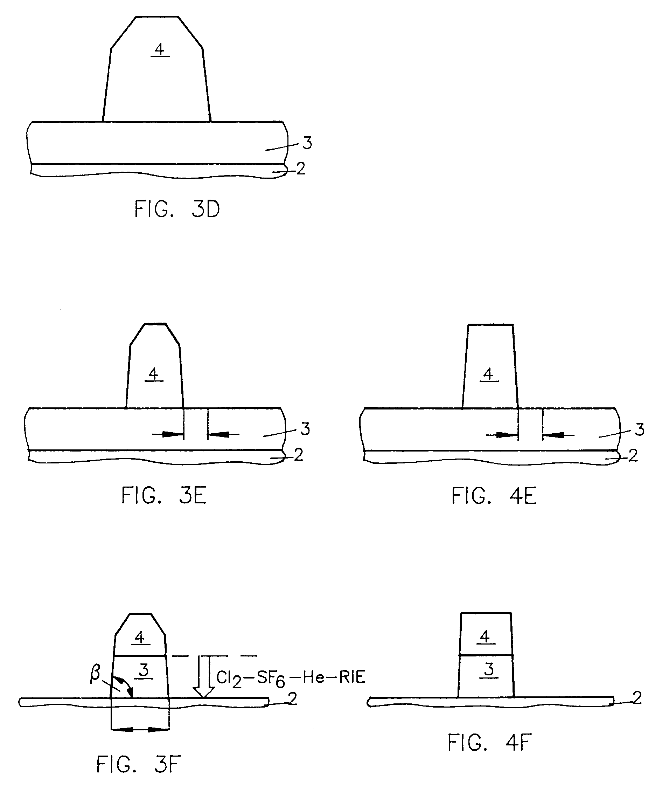

Es wurde daher anstelle des zuvor geschilderten Verfahrens nach dem Stand der Technik ein mehrstufiges Ätzverfahren entwickelt, das eine äußerst genaue Kontrolle der lateralen Ätzung der Photoresiststrukturen (4) (Fign. 3 und 4) zuläßt.

Es wird ausgegangen von der Schichtstruktur, die in Fig. 1 dargestellt ist. Die Photoresistmaske (6) aus TNS-Resist wird, wie oben angegeben, durch konventionelles Belichten und Entwickeln in einem Flüssigentwickler hergestellt. Dabei wird ein positiver Resistwinkel in einem Bereich von etwa 75 bis 85° erhalten. Alle Trockenätzschritte können entweder in einem Parallelplattenreaktor, einem Plasmaätzgerät oder einer Hexode, beispielsweise vom Typ AME 8121, durchgeführt werden. Die Parameter für die einzelnen Ätzschritte sind geräteabhängig.

Das neue Verfahren verwendet die Nitridschicht (5) (Fign. 3A,B und 4A,B) lediglich, um an den durch die Photoresistmaske (6) (Fign. 3A, 4A) definierten Stellen in den darunterliegenden Photoresist (4) einen Winkel von etwa 80 bis 85° zu ätzen. Anschließend wird die Nitridschicht (5) durch reaktives Ionenätzen entfernt. Der positive Winkel der Photoresiststruktur (4) kann durch einen Facettierschritt in Sauerstoff noch verstärkt werden, ehe die für die Verschmälerung wesentliche, laterale Ätzung der Photoresiststruktur (4) in Sauerstoff vorgenommen wird. Bei diesem Schritt können, wegen des Photoresistwinkels von < 90°, die Bedingungen für das reaktive Ionenätzen mit Sauerstoff so gewählt werden, daß ein überwiegend anisotropes Ätzen stattfindet, welches präziser abläuft als isotropes Ätzen unter einem Überhang der Nitridschicht (5) und welches deshalb über die Ätzzeit genau einstellbar ist. Es wird auch der Einfluß benachbarter Strukturen auf die laterale Ätzung stark verringert, weil kein abschattendes Nitrid mehr vorhanden ist.

Gemäß der Erfindung wurde eine laterale Ätzung der Photoresiststruktur bis zu insgesamt etwa 0.75 µm erzielt bei einer 3sigma- Toleranz (sigma = Standardabweichung) von nur etwa ± 0.08 µm über den einzelnen Wafer und etwa ± 0.12 µm über das gesamte Los von 16 Wafern, d. h. die von vornherein bestehende Toleranz aus der Photolithographie von etwa ± 0.1 µm wurde kaum vergrößert.

Mit der Photoresistmaske mit Winkeln von < 90° und den um einen gewünschten Betrag verschmälerten Photoresiststegen wurde anschliessend durch reaktives Ionenätzen im Polysilicium (3) ein Muster mit positiven Winkeln und den gewünschten Linienbreiten erzeugt, welches im Hinblick auf die geforderten Eigenschaften der FET's sehr erwünscht ist.

In einem speziellen Ausführungsbeispiel wird die Schichtstruktur von Fig. 1 mit der Photoresistmaske (6), welche auf konventionelle Art und Weise hergestellt wurde, in einer Hexode vom Typ AME 8121 einer Reihe von Trockenätzschritten unterworfen.

Die Nitridschicht (5) der Schichtstruktur bestehend aus einer 0.8 µm dicken Photoresistmaske (6) auf einer 0.1 µm dicken Nitridschicht (5), einer 1.1 µm dicken Photoresistschicht (4) und einer 430 nm dicken Polysiliciumschicht (3) wird unter folgenden Bedingungen geätzt (Fig. 3A):

| | |
|---|---|
| CF₄-Fluß | 20 bis 50 sccm; |
| Druck | 30 bis 60 µbar; |
| Energiedichte | 0.3 bis 0.5 Watt/cm²; |

bei 30 %iger Überätzung.

Die Photoresistschicht (4) wird unter folgenden Bedingungen anisotrop geätzt (Fig. 3B):

| | |
|---|---|
| O₂-Fluß | 40 bis 60 sccm; |
| Druck | 8 bis 12 µbar; |
| Energiedichte | 0.2 bis 0.4 Watt/cm². |

Ätzstop bei einer Photoresistdicke von etwa 0.2 µm vor dem Endpunkt.

Dann wird die Nitridschicht (5) unter folgenden Bedingungen abgeätzt (Fig. 3C):

| | |
|---|---|
| CF₄-Fluß | 20 bis 50 sccm; |
| Druck | 30 bis 60 µbar; |
| Energiedichte | 0.3 bis 0.5 Watt/cm². |

Gleichzeitig werden etwa 0.1 µm der Photoresistschicht (4) abgeätzt.

Falls erwünscht, wird ein Facettierschritt unter folgenden Bedingungen durchgeführt (Fig. 3D):

| | |
|---|---|
| O₂-Fluß | 15 bis 25 sccm; |
| Druck | < 1 µbar; |
| Energiedichte | 0.2 bis 0.4 Watt/cm². |

Die restlichen 0.1 µm der Photoresistschicht (4) werden bei diesem Schritt abgeätzt.

Anschliessend wird eine laterale Ätzung zur Verschmälerung der Photoresiststruktur (4) unter folgenden Bedingungen durchgeführt (Fig. 3E):

| | |
|---|---|
| O₂-Fluß | 80 bis 120 sccm; |
| Druck | 90 bis 100 µbar; |
| Energiedichte | 0.2 bis 0.4 Watt/cm². |

Die Dauer dieses Ätzschrittes ergibt die Größe der lateralen Ätzung. Bei einer Dauer von etwa 1.6 Min. werden etwa 0.3 µm beidseitig der Photoresiststruktur (4) abgeätzt.

Schließlich wird unter Verwendung der Photoresistmaske (4) die Polysiliciumschicht (3) in einem Parallelplattenreaktor oder in einer Hexode unter folgenden Bedingungen geätzt:

| | |
|---|---|
| Ätzmedium | Cl₂/SF₆/He |
| | 7.5 2.5 90 Vol.%; |
| Fluß | 35 bis 45 sccm; |
| Druck | 40 bis 60 µbar; |
| Erniedrigte Energiedichte | 0.05 bis 0.1 Watt/cm². |

In Abhängigkeit von dem Winkel in der Photoresistmaske (4) wird in der Polysiliciumschicht (3) ein Winkel von < etwa 90° erhalten.

Um die hohe Präzision des lateralen Ätzprozesses (Fig. 3E) zu demonstrieren, wurde versucht, bei einem Waferlos den Beitrag der Photolithographie zu den 3sigma-Toleranzen zu zeigen, d. h. die Schwankungen der Ausgangsbreiten von Resiststrukturen vom Beitrag des reaktiven Ionenätzens zu trennen. In diesem Versuch wurden von 10 Wafern alle geraden Nummern senkrecht durch die Nitridschicht (5) und die Photoresistschicht (4) geätzt, um die Ausgangsbreiten der Resiststrukturen in das Polysilicium (3) zu übertragen.

Alle ungeraden Nummern wurden vor dem reaktiven Ionenätzen des Polysiliciums (3) einer lateralen Ätzung in Sauerstoff von etwa 0.45 µm unterworfen. Bei beiden Teilnummern war die elektrisch gewonnene 3sigma-Toleranz mit etwa 0.1 µm identisch. Dass Schwankungen in der Ausgangsbreite der Resiststrukturen von 0.1 µm über den einzelnen Wafer fast ausschliesslich auf die Photolithographie und die Entwicklung zurückzuführen sind, konnte durch zahlreiche SEM-Messungen bestätigt werden. Damit ist bewiesen, dass der laterale Ätzprozess praktisch keinen Beitrag zu 3sigma-Toleranzen leistet und letztere durch die zuvor genannte Photolithographie und Entwicklung bedingt sind.

In einem weiteren Ausführungsbeispiel (Fign. 4A bis 4F) wurden die einzelnen Ätzschritte nacheinander in einer Hexode vollautomatisch abgearbeitet. In diesem Ausführungsbeispiel wurde auf einen speziellen Facettierschritt (Fig. 3D im vorigen Beispiel) vor der eigentlichen lateralen Ätzung verzichtet. Mit dem vollautomatischen Verfahren konnte eine Photoresiststruktur (4) mit nahezu senkrechten Kanten hergestellt werden, deren Übertragung in die Polysiliciumschicht (3) einen Kantenwinkel von 90° ergibt. Auch in diesem Ausführungsbeispiel werden alle Vorteile des Verfahrens gemäß der Erfindung erhalten.

## Patentansprüche

1. Verfahren zur Herstellung einer integrierten Halbleiterstruktur mit Bauelementen mit Abmessungen im Submikrometerbereich, bei dem
A) drei Schichten (4,5,6) auf ein Halbleitersubstrat (1,2,3) aufgebracht werden, wobei die untere Schicht (4) auf der Oberfläche des Substrats (3) aus einem Photoresist oder Polymermaterial, die mittlere Schicht (5) aus Siliciumnitrid und die oberste Schicht (6) aus einem hochempfindlichen Photoresist besteht;
B) das gewünschte Muster einer Maske in der obersten Photoresistschicht (6) erzeugt wird und anschließend durch reaktives Ionenätzen (RIE) oder Plasmaätzen in die mittlere Siliciumnitridschicht (5), und danach durch RIE mit Sauerstoff in die untere Photoresist- oder Polymerschicht (4) übertragen wird; und
C) das resultierende Muster in der unteren Photoresist- oder Polymerschicht (4) zum Ätzen der obersten Schicht (3) des Halbleitersubstrats dient;
dadurch gekennzeichnet, daß in Schritt B)
die übriggebliebenen Teile der mittleren Nitridschicht (5) durch RIE oder Plasmaätzen entfernt werden;
daraufhin das resultierende Muster in der unteren Photoresist- oder Polymerschicht (4) ggf. einem Facettierschritt in einem Sauerstoff plasma unterworfen wird; und anschließend
das resultierende Muster in der unteren Photoresist- oder Polymerschicht (4) durch laterales Ätzen in einem Sauerstoff plasma in seinen Dimensionen um einen gewünschten Betrag verkleinert wird.

2. Verfahren nach Anspruch 1, dadurch gekennzeichnet, daß die RIE Schritte in derselben Vorrichtung vorgenommen werden.

3. Verfahren nach Anspruch 2, dadurch gekennzeichnet, daß die RIE Schritte in einem Parallelplattenreaktor oder in einer Hexode vorgenommen werden.

4. Verfahren nach Anspruch 1, dadurch gekennzeichnet, daß die mittlere Nitridschicht (5) mit CF₄ bei einem Gasfluß von 20 bis 50 sccm, einem Druck von 30 bis 60 µbar und einer Energiedichte von 0.3 bis 0.5 Watt/cm² geätzt wird.

5. Verfahren nach Anspruch 1, dadurch gekennzeichnet, daß die untere Photoresist- oder Polymerschicht (4) mit Sauerstoff bei einem Druck von < 12 µbar geätzt wird, wodurch in dem resultierenden Muster in der unteren Photoresist- oder Polymerschicht (4) sich vom Substrat aus unter einem Winkel (α) von 80 bis 85° verjüngende Musterquerschnitte erhalten werden.

6. Verfahren nach Anspruch 5, dadurch gekennzeichnet, daß die untere Photoresist- oder Polymerschicht (4) mit O₂ bei einem Gasfluß von 40 bis 60 sccm, einem Druck von 8 bis 12 µbar und einer Energiedichte von 0.2 bis 0.4 Watt/cm² anisotrop geätzt wird.

7. Verfahren nach den Ansprüchen 1, 5 und 6, dadurch gekennzeichnet, daß das Muster in der unteren Photoresist- oder Polymerschicht (4) einem Facettierschritt in Sauerstoff bei einem Gasfluß von 15 bis 25 sccm, einem Druck von < 1 µbar und einer Energiedichte von 0.2 bis 0.4 Watt/cm² unterworfen wird.

8. Verfahren nach Anspruch 1, dadurch gekennzeichnet, daß das Muster in der unteren Photoresist- oder Polymerschicht (4) nach dem Entfernen der übriggebliebenen Teile der mittleren Nitridschicht (5) bei einem Sauerstoffdruck von etwa 100 µbar für eine bestimmte Zeit lateral geätzt wird, um eine Verkleinerung ihrer Dimensionen um einen bestimmten Betrag zu erreichen.

9. Verfahren nach Anspruch 8, dadurch gekennzeichnet, daß das Muster in der unteren Photoresist- oder Polymerschicht(4) mit O₂ bei einem Gasfluß von 80 bis 120 sccm, einem Druck von 90 bis 100 µbar und einer Energiedichte von 0.2 bis 0.4 Watt/cm² lateral geätzt wird.

10. Verfahren nach Anspruch 1, dadurch gekennzeichnet, daß das Muster in der unteren Photoresist- oder Polymerschicht (4) zum Ätzen einer Struktur in die oberste Schicht (3) des Halbleitersubstrats verwendet wird, wobei die Strukturquerschnitte sich vom verbleibenden Substrat aus unter einem Winkel (β) < 90° verjüngen.

11. Verfahren nach Anspruch 10, dadurch gekennzeichnet, daß die oberste Schicht (3) des Halbleitersubstrats aus Polysilicium besteht und zum RIE derselben eine Mischung von, in Volum%, 6 bis 8 % SF₆, 2 bis 3 % Cl₂, Rest Helium verwendet wird.

12. Verfahren nach einem oder mehreren der Ansprüche 1 bis 10, dadurch gekennzeichnet,
daß die untere Photoresist- oder Polymerschicht (4) aus einer etwa 1.1 µm dicken Schicht aus einem Resist auf Phenolharzbasis und einem Bis-ester einer 1-Oxo-2-naphthalinsulfonsäure mit einem asymmetrischen primären oder sekundären aliphatischen Diol als Sensibilisator; die mittlere Schicht (5) aus einer etwa 0.1 µm dicken Plasmanitridschicht; und die oberste Schicht (6) aus einer etwa 0.8 µm dicken Photoresistschicht, aus dem gleichen Material der unteren Schicht (4), besteht.

13. Anwendung des Verfahrens nach den Ansprüchen 1 bis 12 zur Herstellung von FET's mit Kanallängen im Submikrometerbereich.

## Claims

1. Method of producing an integrated semiconductor structure comprising components with dimensions in the submicron range, wherein
A) three layers (4, 5, 6) are deposited on a semiconductor substrate (1, 2, 3), the bottom layer (4) on the surface of the substrate (3) consisting of a photoresist or polymer material, the center layer (5) of silicon nitride and the top layer (6) of a highly sensitive photoresist;
B) the desired pattern of a mask is generated in the top photoresist layer (6) to be subsequently transferred by reactive ion etching (RIE) or plasma etching to the center silicon nitride layer (5), and then, by RIE with oxygen, to the bottom photoresist or polymer layer (4), and
C) the resulting pattern in the bottom photoresist or polymer layer (4) serves to etch the top layer (3) of the semiconductor substrate,
characterized in that in step B) remaining portions of the center nitride layer (5) are removed by RIE or plasma etching;
the resulting pattern in the bottom photoresist or polymer layer (4) is subjected, if necessary, to a facetting step in an oxygen plasma, and
the resulting pattern in the bottom photoresist or polymer layer (4) is then reduced in its dimensions by a desired amount with the aid of lateral etching in an oxygen plasma.

2. Method according to claim 1,
characterized in that the RIE steps are carried out in the same arrangement.

3. Method according to claim 2,
characterized in that the RIE steps are carried out in a parallel plate reactor or in a hexode.

4. Method according to claim 1,
characterized in that the center nitride layer (5) is etched with CF₄, using a gas flow of 20 to 50 sccm, a pressure of 30 to 60 µbar, and an energy density of 0.3 to 0.5 Watt/cm².

5. Method according to claim 1,
characterized in that the bottom photoresist or polymer layer (4) is etched with oxygen at a pressure of < 12 µbar so that in the resulting pattern in the bottom photoresist or polymer layer (4) pattern cross-sections tapering from the substrate at an angle (α) of 80 to 85° are obtained.

6. Method according to claim 5,
characterized in that the bottom photoresist or polymer layer (4) is anisotropically etched with O₂, using a gas flow of 40 to 60 sccm, a pressure of 8 to 12 µbar, and an energy density of 0.2 to 0.4 Watt/cm².

7. Method according to claims 1, 5, 6,
characterized in that the pattern in the bottom photoresist or polymer layer (4) is subjected to a facetting step in oxygen, using a gas flow of 15 to 25 sccm, a pressure of < 1 µbar, and an energy density of 0.2 to 0.4 Watt/cm².

8. Method according to claim 1,
characterized in that the pattern in the bottom photoresist or polymer layer (4), after removal of the remaining portions of the center nitride layer (5), is laterally etched at an oxygen pressure of about 100 µbar for a predetermined time to reduce its dimensions by a predetermined amount.

9. Method according to claim 8,
characterized in that the pattern in the bottom photoresist or polymer layer (4) is laterally etched with O₂ at a gas flow of 80 to 120 sccm, a pressure of 90 to 100 µbar, and an energy density of 0.2 to 0.4 Watt/cm².

10. Method according to claim 1,
characterized in that the pattern in the bottom photoresist or polymer layer (4) is used to etch a structure into the top layer (3) of the semiconductor substrate, with the structural cross-sections tapering from the remaining substrate at an angle (β) < 90°.

11. Method according to claim 10,
characterized in that the top layer (3) of the semiconductor substrate consists of polysilicon and a mixture, in volume per cent, of 6 to 8 % SF₆, 2 to 3 % Cl₂, remainder helium, is used for its RIE.

12. Method according to any one or a combination of claims 1 to 10,
characterized in that the bottom photoresist or polymer layer (4) consists of an about 1.1 µm thick layer of a resist based on phenolic resin and a diester of a 1-oxo-2-diazo-naphthalene sulfonic acid with an asymmetrical primary or secondary alphatic diol as a sensitizer; the center layer (5) of an about 0.1 µm thick plasma nitride layer; and the top layer (6) of an about 0.8 µm thick photoresist layer of the same material as the bottom layer (4).

13. Use of the method according to claims 1 to 12 to produce FETs with channel lengths in the submicron range.

## Revendications

1. Procédé de fabrication d'un circuit intégré à semi-conducteurs comportant des composants ayant des dimensions dans la plage submicronique, selon lequel
(A) trois couches (4, 5, 6) sont appliquées sur un substrat semi-conducteur (1, 2, 3), la couche inférieure (4) appliquée sur la surface du substrat (3) étant constituée d'un photorésist ou d'un matériau polymère, la couche médiane (5) de nitrure de silicium et la couche supérieure (6) d'un photorésist très sensible ;
(B) le motif souhaité d'un masque est produit dans la couche supérieure de photorésist (6), puis transmis dans la couche médiane de nitrure de silicium (5) par attaque ionique réactive (RIE) ou attaque au plasma, et ensuite dans la couche inférieure (4) de photorésist ou de polymère par RIE à l'oxygène ; et
(C) le motif obtenu dans la couche inférieure de photorésist ou de polymère (4) sert à attaquer la couche supérieure (3) du substrat semi-conducteur ;
caractérisé en ce qu'à l'étape (B), les parties de la couche médiane de nitrure (5) qui sont restées présentes sont enlevées par RIE ou attaque au plasma ; à la suite de quoi, le motif obtenu dans la couche inférieure (4) de photorésist ou de polymère est éventuellement soumis à une étape de taille à facettes dans un plasma à l'oxygène ; et enfin, on réduit d'une quantité souhaitée les dimensions du motif obtenu dans la couche inférieure (4) de photorésist ou de polymère, par attaque latérale dans un plasma à l'oxygène.

2. Procédé selon la revendication 1, caractérisé en ce que les différentes étapes de RIE sont mises en oeuvre dans le même dispositif.

3. Procédé selon la revendication 2, caractérisé en ce que les différentes étapes de RIE sont mises en oeuvre dans un réacteur à plaques parallèles ou dans une hexode.

4. Procédé selon la revendication 1, caractérisé en ce que la couche médiane de nitrure (5) est attaquée au CF₄ avec un débit de gaz de 20 à 50 cm³/mn, une pression de 30 à 60 µbars et une densité d'énergie de 0,3 à 0,5 Watt/cm².

5. Procédé selon la revendication 1, caractérisé en ce que la couche inférieure (4) de photorésist ou de polymère est attaquée à l'oxygène à une pression inférieure à 12 µbars, de sorte que l'on obtient, dans le motif obtenu dans la couche inférieure (4) de photorésist ou de polymère, des sections de motif qui, à partir du substrat, se rétrécissent sous un angle (α) de 80 à 85°.

6. Procédé selon la revendication 5, caractérisé en ce que la couche inférieure (4) de photorésist ou de polymère est attaquée anisotropiquement à l'oxygène avec un débit de gaz de 40 à 60 cm³/mn, une pression de 8 à 12 µbars et une densité d'énergie de 0,2 à 0,4 Watt/cm².

7. Procédé selon les revendications 1, 5 et 6, caractérisé en ce que le motif obtenu dans la couche inférieure (4) de photorésist ou de polymère est sousmis à une étape de taille à facettes dans de l'oxygène, avec un débit de gaz de 15 à 25 cm³/mn, une pression inférieure à 1 µbar et une densité d'énergie de 0,2 à 0,4 Watt/cm².

8. Procédé selon la revendication 1, caractérisé en ce que le motif obtenu dans la couche inférieure (4) de photorésist ou de polymère est, après avoir enlevé les parties restées présentes de la couche médiane de nitrure (5), attaqué latéralement pendant une durée déterminée à une pression d'oxygène d'environ 100 µbars, afin d'obtenir une réduction de ses dimensions d'une valeur donnée.

9. Procédé selon la revendication 8, caractérisé en ce que le motif obtenu dans la couche inférieure (4) de photorésist ou de polymère est attaqué latéralement à l'oxygène avec un débit de gaz de 80 à 120 cm³/mn, une pression de 90 à 100 µbars et une densité d'énergie de 0,2 à 0,4 Watt/cm².

10. Procédé selon la revendication 1, caractérisé en ce que le motif obtenu dans la couche inférieure (4) de photorésist ou de polymère est utilisé pour attaquer une structure dans la couche supérieure (3) du substrat semi-conducteur, les sections de la structure se rétrécissant, à partir du substrat résiduel, sous un angle (β) inférieur à 90°.

11. Procédé selon la revendication 10, caractérisé en ce que la couche supérieure (3) du substrat semiconducteur est constituée de polysilicium, et on utilise pour sa RIE un mélange, en pourcentage volumique, de 6 à 8 % de SF₆ et 2 à 3 % de Cl₂ , le reste étant de l'hélium.

12. Procédé selon une ou plusieurs des revendications 1 à 10, caractérisé en ce que la couche inférieure (4) de photorésist ou de polymère est une couche d'environ 1,1 µm d'épaisseur constituée d'un résist à base de résine phénolique et d'un di-ester d'un acide naphtaline-sulfonique 1-oxo-2, avec un diol aliphatique asymétrique primaire ou secondaire comme sensibilisateur ; la couche médiane (5) est une couche de nitrure déposée au plasma d'environ 0,1 µm d'épaisseur ; et la couche supérieure (6) est une couche de photorésist d'environ 0,8 µm d'épaisseur, constituée du même matériau que la couche inférieure (4).

13. Application du procédé selon les revendications 1 à 12 pour la fabrication de transistors à effet de champ ayant des canaux de longueurs submicroniques.
